## Europäisches Patentamt
## European Patent Office
## Office européen des brevets

(19)

(11) Numéro de publication: **0 156 683**
**B1**

# FASCICULE DE BREVET EUROPEEN

(12)

(45) Date de publication du fascicule du brevet:
**08.11.89**

(51) Int. Cl.⁴: **G 03 B 41/00**

(21) Numéro de dépôt: **85400335.7**

(22) Date de dépôt: **22.02.85**

---

(54) **Appareil de microlithographie optique à système d'alignement local.**

---

(30) Priorité: **28.02.84 FR 8403027**

(43) Date de publication de la demande:
**02.10.85 Bulletin 85/40**

(45) Mention de la délivrance du brevet:
**08.11.89 Bulletin 89/45**

(84) Etats contractants désignés:
**CH DE GB LI NL**

(56) Documents cités:
**DE-A- 1 597 431**
**FR-A- 2 082 213**
**FR-A- 2 128 822**
**US-A- 3 718 396**
**US-A- 3 844 655**

**Bauelemente der Optik, H. Naumann/G. Schröder, pp. 186,187**

(73) Titulaire: **COMMISSARIAT A L'ENERGIE ATOMIQUE,**
**31/33, rue de la Fédération, F-75015 Paris (FR)**

(72) Inventeur: **Picard, Bernard, 8, rue Georges Bizet,**
**F-38400 Saint Martin d'Heres (FR)**

(74) Mandataire: **Mongrédien, André et al, c/o**
**BREVATOME 25, rue de Ponthieu, F-75008 Paris (FR)**

---

## Description

La présente invention a pour objet un appareil de microlithographie optique utilisé notamment pour la fabrication des circuits intégrés. Elle concerne plus particulièrement le système d'alignement local.

On sait qu'un circuit intégré est fabriqué par une succession de dépôts de couches et de gravure de ces couches. Pour réaliser un motif par gravure, on recouvre le circuit intégré d'une couche de résine photosensible et on insole cette résine avec un faisceau énergétique qui est intercepté par un masque reproduisant l'image du motif à réaliser sur le circuit intégré. La résine insolée est ensuite éliminée laissant à nu les zones du circuit intégré à graver.

Pour des circuits dont la dimension minimale des motifs (largeur des conducteurs métalliques, longueur des canaux des transistors MOS,...) est de l'ordre de 3 μm au moins, la méthode la plus courante consiste à réaliser un masque à l'échelle 1. Cette méthode, dite projection 1:1, est intéressante par son faible coût et par sa simplicité qui permet une production à haut débit.

Cette méthode simple ne peut être utilisée pour la fabrication des circuits intégrés dont la dimension typique des motifs est de l'ordre de 1 μm. La fabrication de tels circuits est réalisée principalement par deux méthodes: la microlithographie optique et la microlithographie par faisceau d'électrons.

L'appareil de l'invention est basé sur la première méthode. Plus particulièrement, il met en œuvre la méthode de photorépétition directe sur tranche (en anglais «direct step on wafer»). Dans cette méthode le rapport des dimensions respectives d'un masque et d'un circuit intégré est de l'ordre de 10 à 1; un objectif de photoréduction est donc disposé entre ceux-ci.

Pour positionner successivement chaque circuit intégré d'une plaquette au droit du masque en vue de l'insoler, l'appareil comprend un moyen de déplacement de la plaquette. Les circuits intégrés étant disposés régulièrement sur la plaquette, ce moyen effectue un déplacement de la plaquette d'un pas constant entre deux insolations. La longueur du déplacement peut être contrôlée par exemple par une méthode mettant en œuvre l'interférence de faisceaux laser.

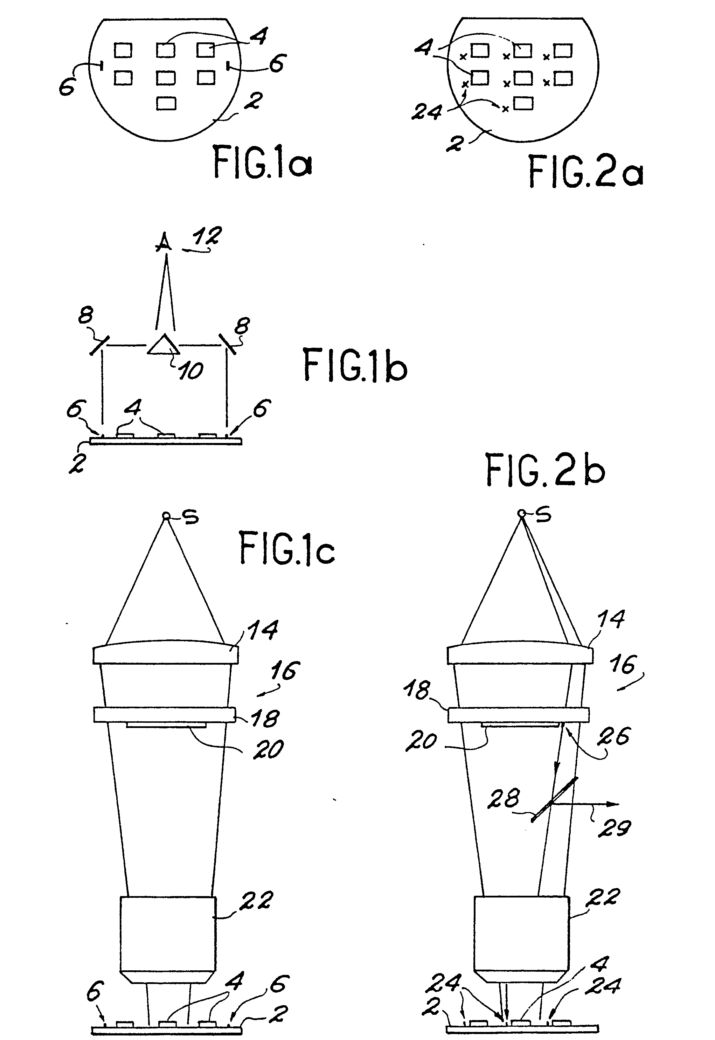

Deux méthodes connues sont utilisées pour aligner les circuits intégrés d'une plaquette dans l'axe optique de l'appareil. On va décrire ces deux méthodes en référence aux figures 1 et 2. Ces méthodes sont respectivement la méthode d'alignement global et la méthode d'alignement local.

Les figures 1a, 1b et 1c illustrent la méthode d'alignement global d'une plaquette. La figure 1a représente, en vue de dessus, une plaquette 2 comportant une pluralité de zones rectangulaires 4 disposées régulièrement sur cette plaquette. Sur ces zones, des couches successives seront déposées puis gravées créant ainsi un circuit intégré. On appellera «puces» ces zones dans la suite du texte.

Outre ces puces, la plaquette 2 comporte également des marques de repérage 6 qui sont utilisées pour aligner ladite plaquette. Ces marques peuvent être constituées d'un simple trait, comme représenté sur la figure, ou peuvent être à deux dimensions, par exemple une croix. Dans le premier cas au moins deux marques sont nécessaires pour positionner la plaquette en translation et en rotation; dans le second cas, une seule marque suffit.

L'alignement de la plaquette est réalisé par un système optique chematisé sur la figure 1b. Le système optique représenté comprend deux miroirs d'angle 8, un prisme 10 et un microscope d'alignement 12. Ce système optique est relié à un moyen qui commande le déplacement du support de la plaquette de telle sorte que les marques de repérage 6 occupent des positions de référence.

La plaquette est ensuite translatée pour être positionnée sous la colonne optique du système de microlithographie. Ce système optique comprend une source S de lumière monochromatique, une lentille convergente 14, un réticule 16, constitué d'une lame de verre 18 sur la face inférieure de laquelle un masque 20 est réalisé par dépôt puis gravure d'une feuille métallique, et un objectif de photoréduction 22. Chaque puce 4 de la plaquette 2 est insolée successivement.

L'alignement correct de chaque puce 4 avant insolation n'est pas contrôlé. Ceci permet de gagner du temps et donc d'avoir un débit élevé, mais ceci conduit en revanche à une tolérance importante dans l'alignement des différentes couches constituant la puce. Sur les machines connues, ce défaut d'alignement est de l'ordre de 0,7 μm et est dû pour une grande part au déplacement de la plaquette du système d'alignement au système de microlithographie optique, ce déplacement étant d'une longueur d'approximativement 100 mm.

Cette tolérance de 0,7 μm dans l'alignement des puces interdit pratiquement de réaliser des motifs de dimension inférieure à 2 μm. Pour les lithographies plus fines, il est nécessaire d'utiliser un appareil muni d'un système d'alignement local, c'est-à-dire un système permettant de réaligner chaque puce de la plaquette avant insolation. Un tel appareil est représenté schématiquement sur les figures 2a et 2b.

La figure 2a représente en vue de dessus une plaquette 2 comportant une pluralité de puces 4. Une marque de repérage 24 est disposée à côté de chacune des puces. Ces marques permettent d'aligner individuellement chaque puce sous le système de microlithographie optique. Ces marques peuvent être à une dimension, par exemple un trait, ou à deux dimensions, par exemple une croix.

Le système de microlithographie optique de la figure 2b comporte les mêmes éléments que celui de la figure 1c, c'est-à-dire une source monochromatique S, une lentille convergente 14, un réticule 16 constitué d'une lame de verre 18 et d'un masque 20 et un objectif de photoréduction 22.

Une marque de référence 26 a été ajoutée sur la lame 18 à côté du masque 20. Cette marque est projetée par l'objectif de photoréduction 22 sur la plaquette 2. L'alignement correct d'une puce de la plaquette est réalisé en faisant coïncider la projection de cette marque 26 avec la marque de repérage 24 de la puce située sous l'objectif de photoréduction. L'image de la marque 26 sur la plaquette 2 et la zone alentour est renvoyée par un séparateur de faisceau 28 disposé entre le réticule 16 et l'objectif de photoréduction 22 pour être analysée. Un moyen de déplacement commande alors le mouvement de la plaquette en fonction de ce signal 29 afin d'aligner correctement la puce 4 à insoler.

Le document FR-A-128 822 décrit une variante de réalisation dans laquelle le séparateur de faisceau est constitué par deux réflecteurs à 45° disposés entre l'objectif de photoréduction et la plaquette.

L'alignement local permet une meilleure précision dans la superposition des différentes couches d'une puce. La précision d'alignement est ici de l'ordre de 0,1 μm, ce qui est nettement meilleur que dans les appareils dotés d'un système d'alignement global. Il est ainsi possible de réaliser des circuits intégrés dont la dimension minimale des motifs est de l'ordre de 1 μm.

On comprend que l'alignement de chaque puce pénalise le débit de production des circuits intégrés par rapport à l'alignement global. Pour ne pas trop limiter ce débit, le réalignement n'est pas réalisé toute les puces, mais toutes les n puces, la valeur de n étant choisie en fonction des caractéristiques de l'appareil.

Le système d'alignement local de l'appareil représenté sur la figure 2b n'est pas parfait. Une première limitation de ce système réside dans le fait que l'objectif de photoréduction 22 n'est corrigé que pour une longueur d'onde précise qui est la longueur d'onde de la source monochromatique S. Un alignement correct ne peut donc se faire qu'avec cette source. Ceci est gênant car la marque de repérage 24 se trouvant dans le champ de l'objectif de photoréduction 22 est attaquée par le rayonnement issu de la source S.

D'autre part, selon les niveaux technologiques, la marque de repérage 24 peut être très peu contrastée, ce qui rend difficile l'alignement de la puce 4 associée.

Le système d'alignement local de l'appareil de l'invention remédie à ces problèmes en autorisant l'éclairage de la marque 24 par un faisceau optique à large spectre ou par le choix d'un faisceau monochromatique dont la longueur d'onde peut être choisie parmi une pluralité. Parmi les sources d'éclairement disponibles, on pourra ainsi utiliser avantageusement une longueur d'onde à laquelle la résine recouvrant la puce est insensible.

L'objectif de photoréduction, qui est dépourvu d'aberrations pour une seule longueur d'onde, n'est pas compatible avec la source d'éclairement de l'invention. Par ailleurs, un objectif de photoréduction dépourvu d'aberrations pour une gamme de longueurs d'ondes est pratiquement impossible à réaliser dans l'état actuel de la technique.

On se propose donc de disposer un séparateur de faisceau entre l'objectif de photoréduction et la plaquette pour éclairer celle-ci sans utiliser les moyens du système optique de microlithographie.

Ce séparateur de faisceau a aussi pour rôle de renvoyer l'image de la zone entourant la marque de repérage de la puce à insoler, image qui est ensuite traitée par un moyen qui commande le déplacement de la plaquette pour réaliser l'alignement de la puce à insoler.

De manière précise, l'invention a pour objet un appareil de microlithographie optique comprenant un support recevant une plaquette sur laquelle sont réparties des puces à insoler munies chacune d'au moins une marque de repérage en position, un système optique, et un système d'alignement local de la plaquette, ledit système optique comprenant une source de rayonnement, une lentille convergente, un réticule et un objectif de photoréduction pour afficher l'image du réticule sur une puce de la plaquette, ledit système d'alignement local comprenant un séparateur de faisceau entre l'objectif de photoréduction et la plaquette, une source d'éclairement de la plaquette par ledit séparateur de faisceau, au moins un objectif de visée pour recueillir par ledit séparateur de faisceau l'image de la zone éclairée autour de la marque de repérage, au moins un motif d'alignement se trouvant dans le plan focal de chacun desdits objectifs de visée et un moyen pour commander le déplacement du support de plaquette pour aligner l'image de la marque de repérage sur le morif d'alignement, ledit appareil étant caractérisé en ce que le séparateur de faisceau forme avec l'objectif de photoréduction un tout optiquement et mécaniquement indissociable.

L'objectif de photoréduction n'est pas utilisé par le système d'alignement. La lumière issue de la source d'éclairement n'est transmise, et déviée, que par le séparateur de faisceau, et l'image de la puce recueillie après réflexion de cette lumière n'est transmise et déviée que par ledit séparateur de faisceau.

Selon l'invention, la source d'éclairement peut être soit à large spectre, soit monochromatique. Une source monochromatique peut être notamment obtenue en interposant un filtre sur le trajet d'un faisceau à large spectre.

Selon une autre caractéristique de l'invention, le système d'alignement comprend deux motifs d'alignement et deux moyens pour recueillir l'image de deux marques de repérage associées à une puce, le moyen de déplacement déplaçant la plaquette pour aligner chaque marque de repérage avec un motif d'alignement.

Selon une autre caractéristique de l'invention, chaque moyen pour recueillir l'image de la marque de repérage est un objectif de visée ayant dans son plan focal le motif d'alignement.

Les caractéristiques et avantages de l'invention ressortiront mieux de la description qui va suivre, donnée à titre illustratif mais non limitatif, en référence aux dessins annexés, dans lesquels:

— les figures 1a, 1b et 1c, déjà décrites, illustrent schématiquement un appareil de microlithographie optique muni d'un système d'alignement global selon l'art connu,

— les figures 2a et 2b, déjà décrites, illustrent un appareil de microlithographie optique muni d'un système d'alignement local selon l'art connu,

— la figure 3 représente schématiquement un appareil de microlithographie optique muni d'un système d'alignement local selon l'invention,

— la figure 4 représente schématiquement un autre mode de réalisation du système d'alignement local d'un appareil de microlithographie optique selon l'invention.

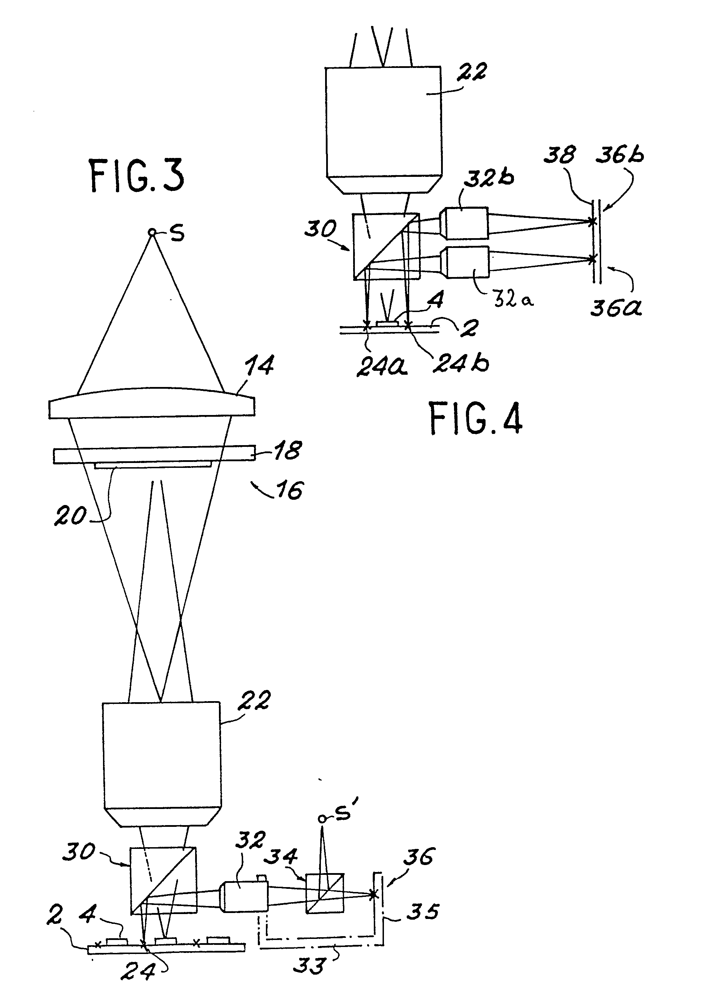

Le système optique de microlithographie de l'appareil représenté sur la figure 3 est classique. Il comprend une source monochromatique S, une lentille convergente 14, un réticule 16 composé d'une lame de verre 18 sur la face inférieure de laquelle est gravé un masque 20, et un objectif de photoréduction 22. Un moyen de déplacement non représenté positionne successivement chaque puce 4 de la plaquette 2 dans l'axe du système optique de microlithographie pour les insoler.

Selon l'invention, le système d'alignement local de l'appareil de microlithographie optique comprend un séparateur de faisceau 30 disposé dans l'axe du système optique entre l'objectif de photoréduction 22 et la plaquette 2, un objectif de visée 32 pour recueillir l'image de la zone de la plaquette centré sur la marque de repérage 24 associée à la puce 4 à insoler, une source d'éclairement S', un second séparateur de faisceau 34 et un motif d'alignement 36.

Le séparateur de faisceau 30 peut être notamment un cube séparateur ou un miroir dichroïque. Ce séparateur de faisceau 30 forme, avec l'objectif de photoréducteur 22 un tout, optiquement et mécaniquement indissociable.

Ceci présente l'avantage que l'insolation peut continuer au travers de ce séparateur de faisceau, entre deux visées de réglage par le système d'alignement, sans qu'un déplacement mécanique de ce séparateur de faisceau n'intervienne. Le débit d'insolation des puces est ainsi augmenté.

Le séparateur de faisceau 30 peut aussi être constitué d'un miroir escamotable. Dans ce cas, il peut être nécessaire de déplacer le miroir pour permettre l'insolation. Le débit d'insolation des puces est alors moins important.

La lentille 14, l'objectif de photoréduction 22 et le séparateur de faisceau 30 sont alignés sur l'axe optique de l'appareil. Ils sont fixés par rapport à cet axe. L'alignement du réticule est obtenu, de manière connue, par la mise en coïncidence de marques de repérage sur ce réticule avec des marques de repérage sur le porte-réticule (non représenté).

Pour positionner la puce 4 à insoler, la plaquette 2 est éclairée par la source S' du système d'alignement local, le faisceau de la source S étant occulté. L'objectif de visée 32 a deux degrés de liberté en translation dans le plan perpendiculaire à l'axe du système optique de microlithographie. Il est déplacé de manière connue, soit manuellement, soit automatiquement, pour que la marque de repérage 24 associée à la puce 4 tombe dans son champ de vision. Le motif d'alignement 36 suit les déplacements de l'objectif de visée, par exemple en étant solidaire de cet objectif de visée par l'intermédiaire d'un bâti 33, afin d'être maintenu dans le plan focal 35 de l'objectif de visée 32. Des moyens optiques annexes non représentés, tels que des renvois d'angle, permettent au faisceau issu de la source S' d'éclairer la plaquette 2 par l'intermédiaire du séparateur de faisceau 34 et de l'objectif 32 quelle que soit la position de ce dernier.

L'alignement de la puce 4 est réalisé par la comparaison de la position du motif d'alignement 36 et de l'image de la marque de repérage 24 dans le plan focal de l'objectif de visée 32. Un moyen commande le déplacement de la plaquette pour faire coïncider ces deux marques. La comparaison de la position du motif d'alignement et de l'image de la marque de repérage peut être réalisée selon tout procédé connu. Ce peut être notamment un procédé photométrique si la marque de repérage et le motif d'alignement sont respectivement une croix mâle et une croix femelle, ou ce peut être un procédé de corrélation si la marque de repérage et le motif d'alignement forment chacun un réseau.

Selon l'invention, la source d'éclairement S' peut être monochromatique ou à large spectre. La source d'éclairement peut ainsi être choisie selon le niveau technologique afin d'avoir toujours une marque de repérage 24 très contrastée. Un mode de réalisation simple de cette source d'éclairement S' polyvalente consiste à utiliser une source S' à large spectre, par exemple de longueur d'onde comprise entre 300 et 800 nanomètres, et un ensemble de filtres amovibles interceptant le faisceau de la source S'. Ces filtres peuvent par exemple être répartis sur la périphérie d'un disque dont la mise en rotation permet de présenter n'importe quel filtre devant la source S'.

L'utilisation d'une telle source S' qui n'est pas monochromatique et de longueur d'onde fixe n'est possible que si l'objectif de visée 32 est corrigé pour les aberrations pour toutes les longueurs d'onde, ce qui peut être aisément réalisé, l'objectif de visée étant un système optique peu complexe.

Le système d'alignement local de l'appareil représenté sur la figure 3 permet d'aligner en translation la plaquette 2, l'alignement en rotation étant réalisé une fois pour toutes au début de l'insolation. Dans certains cas, par exemple lorsque le masque est très complexe, il peut être intéressant de pouvoir réaligner en rotation chaque puce de la plaquette avant insolation. Ceci peut être réalisé avec deux marques de repérage placées aux deux extrémités de chaque puce.

L'alignement en rotation et en position peut être également réalisé si à chaque puce 4 de la plaquette 2 sont associées deux marques de repérage et si le système d'alignement local comporte deux objectifs de visée pour projeter l'image de chacune de ces marques sur motifs d'alignement.

La figure 4 illustre schématiquement un tel système d'alignement. Sur cette figure, on a représenté la partie inférieure du système de microlithographie optique comprenant l'objectif de photoréduction 22 et le séparateur de faisceau 30.

Chaque puce 4 de la plaquette 2 est munie de deux marques de repérage 24a et 24b. Par l'intermédiaire de deux objectifs de visée 32a et 32b, la source d'éclairement (non représentée) éclaire les zones situées autour des marques de repérage 24a et 24b et renvoie l'image de ces zones sur le plan 38, situé dans le plan focal des objectifs de visée 32a et 32b, sur lequel sont inscrits deux motifs d'alignement 36a et 36b.

Il est bien entendu que dans les deux modes de réalisation de l'appareil de l'invention, l'alignement peut être réalisé toutes les puces ou seulement toutes les n puces, où n est un nombre entier supérieur ou égal à 1.

## Revendications

1. Appareil de microlithographie optique comprenant un support recevant une plaquette (2) sur laquelle sont réparties des puces (4) à insoler munies chacune d'au moins une marque (24, 24a, 24b) de repérage en position, un système optique de projection et un système d'alignement local de la plaquette, ledit système optique de projection comprenant une source de rayonnement (S), une lentille convergente (14), un réticule (16) et un objectif de photoréduction (22) pour afficher l'image du réticule (16) sur une puce (4) de la plaquette (2), ledit système d'alignement local comprenant un séparateur de faisceau (30) entre l'objectif de photoréduction (22) et la plaquette (2), une source d'éclairement (S') de la plaquette (2) par ledit séparateur de faisceau, au moins un objectif de visée (32, 32a, 32b) pour recueillir par ledit séparateur de faisceau l'image de la zone éclairée autour de la marque de repérage, au moins un motif d'alignement (36, 36a, 36b) se trouvant dans le plan focal de chacun desdits objectifs de visée et un moyen pour commander le déplacement du support de la plaquette pour aligner l'image de la marque de repérage sur le motif d'alignement, ledit appareil étant caractérisé en ce que le séparateur de faisceau (30) forme avec l'objectif de photoréducteur (22) un tout, optiquement et mécaniquement indissociable.

2. Appareil de microlithographie optique selon la revendication 1, caractérisé en ce que la source d'éclairement (S') délivre un faisceau monochromatique.

3. Appareil de microlithographie optique selon la revendication 1, caractérisé en ce que la source d'éclairement (S') délivre un faisceau à large spectre.

4. Appareil de microlithographie optique selon la revendication 3, caractérisé en ce qu'il comprend au moins un filtre amovible interceptant le faisceau de la source d'éclairement (S').

5. Appareil de microlithographie optique selon l'une quelconque des revendications 1 à 4, dans lequel chaque puce de la plaquette porte au moins deux marques de repérage (24a, 24b) en position, caractérisé en ce qu'il comprend un second motif d'alignement et un second moyen pour recueillir par le séparateur de faisceau l'image de la zone éclairée autour de la seconde marque de repérage et en ce que le moyen de déplacement commande le déplacement du support de plaquette pour aligner chacune des marques de repérage avec un motif d'alignement.

## Patentansprüche

1. Gerät für optische Microlithografie mit einem Träger zur Aufnahme eines Plättchens (2), auf dem zu belichtende Bausteine (4) verteilt sind, die jeweils mit wenigstens einer Positonsbestimmungsmarke (24, 24a, 24b) versehen sind, einem optischen Projektionssystem und einem lokalen Ausrichtungssystem des Plättchens, wobei das optische Projektionssystem eine Strahlenquelle (S), eine Sammellinse (14), ein Fadenkreuz (16) und ein Bildverkleinerungsobjektiv (22) aufweist, um das Abbild des Fadenkreuzes (16) auf einem Baustein (4) des Plätt- chens (2) erscheinen zu lassen, und wobei das lokale Ausrichtungssystem eine Strahlentrenneinrichtung (30) zwischen dem Bildverkleinerungsobjektiv (22) und dem Plättchen (2), eine Beleuchtungsquelle (S') des Plättchens (2), durch die Strahlentrenneinrichtung, wenigstens ein Zielobjektiv (32, 32a, 32b) zum Sammeln der Abbildung der beleuchteten Zone um die Bestimmungsmarke mittels der Strahlentrenneinrichtung, wenigstens einen Ausrichtungsgegenstand (36, 36a, 36b), der sich in der Brennweitenebene jedes der Zielobjektive befindet, und eine Einrichtung zum Steuern der Verschiebung des Trägers des Plättchens aufweist, um die Abbildung der Bestimmungsmarke auf den Ausrichtungsgegenstand auszurichten, dadurch gekennzeichnet, daß die Strahlentrenneinrichtung (30) mit dem Bildverkleinerungsobjektiv (22) eine optisch und mechanisch untrennbare Einheit bildet.

2. Gerät für optische Microlithografie nach Anspruch 1, dadurch gekennzeichnet, daß die Beleuchtungsquelle (S') ein monochromatisches Strahlenbündel liefert.

3. Gerät für optische Microlithografie nach Anspruch 1, dadurch gekennzeichnet, daß die Beleuchtungsquelle (S') ein Strahlenbündel mit einem breiten Spektrum liefert.

4. Gerät für optische Microlithografie nach Anspruch 3, ferner gekennzeichnet durch wenigstens einen verstellbaren Filter zur Aufnahme des Strahlenbündels der Beleuchtungsquelle (S').

5. Gerät für optische Microlithografie nach einem der Ansprüche 1 bis 4, dadurch gekennzeichnet, daß jeder Baustein des Plättchens mindestens zwei Positionsbestimmungsmarken (24a, 24b) aufweist, das ein zweiter Ausrichtungsgegenstand und eine zweite Einrichtung zum Sammeln der Abbildung der erhellten Zone um die zweite Bestimmungsmarke vorgesehen sind und daß die Verschiebungseinrichtung die Verschiebung des Trägers des Plättchens steuert, um jede Bestimmungsmarke auf einen Ausrichtungsgegenstand auszurichten.

## Claims

1. Optical microlithography apparatus comprising a support receiving a wafer (2) over which are distributed the chips (4) to be irradiated, each being provided with at least one position finding mark (24, 24a, 24b), an optical system and a system for the local alignment of the wafer, said optical system comprising a radiation source (S), a convergent lens (14), a reticule (16) and a photoreduction lens (22) for displaying the image of the reticule (16) on a chip (4) of the wafer (2), wherein the said local alignment system comprises a beam splitter (30) between the photoreduction lens (22) and the wafer (2), a source for illuminating (S') the wafer (2) by said beam splitter, at least one sighting lens (32, 32a, 32b) for collecting by said beam splitter the image of the illuminated area around the position finding mark, at least one alignment pattern (36, 36a, 36b) being located in the focal plane of each of said sighting lenses and a means for controlling the displacement of the wafer support in order to align the image of the position finding mark on the alignment pattern, said apparatus being characterized in that the beam splitter (30) forms with the photoreduction lens (22) an optically and mechanically inseparable entity.

2. Optical microlithography apparatus according to claim 1, characterized in that the illumination source (S') supplies a monochromatic beam.

3. Optical microlithography apparatus according to claim 1, characterized in that the illumination source (S') supplies a wide spectrum beam.

4. Optical microlithography apparatus according to claim 3, characterized in that it comprises at least one detachable filter, which intercepts the beam from the illumination source (S').

5. Optical microlithography apparatus according to any one of the claims 1 to 4, in which each chip of the wafer carries at least two position finding marks (24a, 24b), characterized in that it comprises a second alignment pattern and a second means for collecting the image of the illuminated area around the second position finding mark by the beam splitter and wherein the displacement means controls the displacement of the wafer support, in order to align each of the position finding marks with an alignment pattern.

EP 156 683 B1

FIG.1a

FIG.2a

FIG.1b

FIG.2b

FIG.1c

FIG.3

FIG.4

S

14

18

16

20

22

30

2 4

24

32 34

S'

36

35

33

22

32b

38 36b

30

32a

4

2

24a 24b

36a